# EUROPEAN PATENT APPLICATION

(11) **EP 4 730 651 A1**
(43) Date of publication of application: **22.04.2026**
(21) Application number: 24207444.1
(22) Date of filing: 18.10.2024
(51) Int. Cl.: H03K 17/00

(54) **MONOLITHICALLY-INTEGRATED CIRCUIT, SYSTEM, ELECTRONIC DEVICE, METHOD**

(71) Applicant: Infineon Technologies AG, 85579 Neubiberg (DE)
(72) Inventor: SOLOMKO, Valentyn, 81479 München (DE); SYROIEZHIN, Semen, 91052 Erlangen (DE); EßEL, Jochen, 91058 Erlangen (DE)
(74) Representative: 2SPL Patentanwälte PartG mbB

(57) **Abstract**

Provided is a monolithically-integrated circuit. The monolithically-integrated circuit includes a radio frequency, RF, switch. The monolithically-integrated circuit further includes a first terminal configured to receive a first reference voltage signal for an ON-state of the RF switch. The monolithically-integrated circuit further includes a second terminal configured to receive a second reference voltage signal for an OFF-state of the RF switch. The monolithically-integrated circuit further includes decoder circuitry configured to decode a control sequence encoded in at least one of the first and the second voltage signals for controlling a switch state of the RF switch. The monolithically-integrated circuit further includes level-shifter circuitry configured to adjust, based on the control sequence, the switch state of the RF switch by selectively level-shifting a voltage level of one of the first and the second reference voltage signals and supplying the level-shifted first reference voltage signal or the level-shifted second reference voltage signal to the RF switch.

## Description

### Field

The present disclosure relates to a monolithically-integrated circuit, a system, an electronic device, and a method, for adjusting a switch state of a radio frequency switch.

### Background

Radio frequency (RF) switches may be provided in front ends of cellular mobile devices, e.g., as antenna tuning switches. Such a switch may include multiple switch throws (e.g., one to ten) capable of handling RF voltages, e.g. in the range of 40 to 100 Volts. If such a switch is based on an integrated circuit (IC), a supply voltage may be converted into at least two stable reference voltages required for ON-state and OFF-state control of the RF switch. For the reference voltage generation, a temperature-independent and supply-insensitive voltage generator may be used (e.g., implemented in a form of a bandgap voltage reference). Furthermore, a charge pump (or multiple charge pumps) may be utilized to generate required control voltages for the RF switch, which might exceed the supply voltage and be negative with respect to IC ground.

For example, a two-wire or single-wire control interface may be utilized in such techniques, implying that at least two pins dedicated to supply and control are present in the IC interface. A serial programming protocol (for example, MIPI RFFE) may be used for controlling an RF switch in cellular RF front ends. Such protocol may allow multiple tuners (also referred to as "slaves") to hang on a shared control and supply bus driven by an RF modem or RF application processor ("master") of the handheld cellular device.

Depending on a number of throws and electrical properties, a power management and control unit (PMU&Control) of the RF switch may occupy between 10% and 50% of die area, if the RF switch including the above-described components is monolithically-integrated. The PMU&Control may be the same for multiple tuners attached to a common control and supply bus.

Accordingly, there is a demand for improved adjusting of switch states of RF switches.

### Summary

This demand may be satisfied by the subject-matter of the independent claims. Further embodiments or examples are given by the dependent claims, the drawings, and the following description.

According to a first aspect, the disclosure provides a monolithically-integrated circuit. The monolithically-integrated circuit includes an RF switch. The monolithically-integrated circuit further includes a first terminal configured to receive a first reference voltage signal for an ON-state of the RF switch. The monolithically-integrated circuit further includes a second terminal configured to receive a second reference voltage signal for an OFF-state of the RF switch. The monolithically-integrated circuit further includes decoder circuitry configured to decode a control sequence encoded in at least one of the first and the second voltage signals for controlling a switch state of the RF switch. The monolithically-integrated circuit further includes level-shifter circuitry configured to adjust, based on the control sequence, the switch state of the RF switch by selectively level-shifting a voltage level of one of the first and the second reference voltage signals and supplying the level-shifted first reference voltage signal or the level-shifted second reference voltage signal to the RF switch.

According to a second aspect, the disclosure provides a system including a plurality of monolithically-integrated circuits according to the first aspect. The system further includes power management circuitry configured to supply the first reference voltage signal for the plurality of monolithically-integrated circuits.

According to a third aspect, the disclosure provides a wireless communication device including a monolithically-integrated circuit according to the first aspect or a system according to the second aspect.

According to a fourth aspect, the disclosure provides a method for operating an RF switch of a monolithically-integrated circuit. The method includes receiving, at a first terminal of the monolithically-integrated circuit, a first reference voltage signal for an ON-state of the RF switch. The method further includes receiving, at a second terminal of the monolithically-integrated circuit, a second reference voltage signal for an OFF-state of the RF switch. The method further includes decoding a control sequence encoded in at least one of the first and the second voltage signals for controlling a switch state of the RF switch. The method further includes adjusting, based on the control sequence, the switch state of the RF switch by selectively level-shifting a voltage level of one of the first and the second reference voltage signals and supplying the level-shifted first reference voltage signal or the level-shifted second reference voltage signal to the RF switch.

### Brief description of the Figures

Some examples of apparatuses and/or methods will be described in the following by way of example only, and with reference to the accompanying figures, in which
Fig. 1 depicts a schematic diagram of a monolithically-integrated circuit according to the present disclosure;
Fig. 2 depicts a timing diagram according to the present disclosure with a fixed delay for adjusting a switch state;
Fig. 3 depicts a timing diagram according to the present disclosure with a variable delay for adjusting a switch state;
Figs. 4a and 4b depicts a monolithically-integrated circuit according to the present disclosure in which a switch and a capacitance are coupled between the first terminal and the level-shifter circuity;
Fig. 5 depicts a monolithically-integrated circuit according to the present disclosure in which a non-linear element and a capacitance are coupled between the first terminal and the level-shifter circuity;
Fig. 6 depicts a system including a plurality of monolithically-integrated circuits according to the present disclosure in which each monolithically-integrated circuit is supplied with a separate first reference voltage;
Fig. 7 depicts a system including a plurality of monolithically-integrated circuits according to the present disclosure in which each monolithically-integrated circuit is supplied with a same first reference voltage;
Fig. 8 depicts a wireless communication device according to the present disclosure; and
Fig. 9 depicts a method for adjusting a switch state of an RF switch according to the present disclosure.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

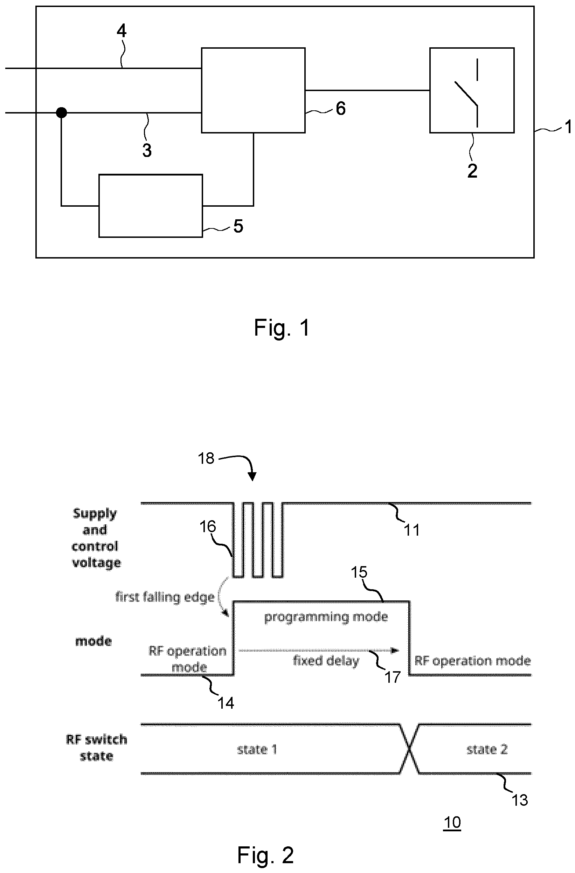

**Fig. 1** depicts a schematic diagram of a monolithically-integrated (electric) circuit 1 according to the present disclosure. Monolithic integration may refer to a process in which the components mentioned in the following are provided (integrated) on a same semiconductor substrate (i.e., on a "monolith"). There may be several ways of manufacturing monolithically-integrated circuits, such as the monolithically-integrated circuit 1, and the choice of technique used for monolithic integration may depend on a specific requirement of an application, such as operating frequency, power levels, manufacturing costs, and the like. In the following, exemplary methods for monolithic integration are listed, but the present disclosure shall not be understood as limited to a specific technique.

Techniques for providing monolithic integration may include silicon-based integration, such as CMOS (complementary metal oxide semiconductor) integration, BiCMOS (bipolar CMOS) integration, GaAs (Gallium Arsenide) integration, SiGe (Silicon Germanium) integration, SOI (silicon-on-insulator) integration, GaN (Gallium Nitride) integration, InP (Indium Phosphide) integration, MMIC (monolithic microwave integrated circuit), thin-film integration, heterogeneous integration (mixing at least two of the above-mentioned integration techniques), or the like.

Also, terms such as "circuit", "circuitry", and the like, shall not be understood as structurally separate components (although this may also be the case, in some instances), but rather in a functional way. For example, "decoder circuitry" and "level shifter circuitry" may be provided by the same structure, which is configured to provide the respective functionalities. For example, circuitry may be based on an application specific integrated circuit (ASIC), a field programmable gate array (FPGA), a microcontroller, or the like. The decoder circuitry 5 and/or the level-shifter circuitry 6 may optionally be coupled to, e.g., read only memory (ROM) for storing software, random access memory (RAM) and/or non-volatile memory.

The monolithically-integrated circuit 1 includes an RF switch 2. The term "RF switch" may pertain to an electronic device configured to control a flow of high-frequency signals, allowing the signal to be directed, blocked, or rerouted between different paths. RF switches may be used in communication systems, radar, and signal testing to switch between antennas, signal paths, or different frequencies. RF switches may have the ability to operate at high frequencies, e.g., from a few MHz (e.g., starting at 1 MHz) to several GHz (e.g., up to 999 GHz), with minimal signal loss and high isolation between paths.

The monolithically-integrated circuit 1 further includes a first terminal 3 and a second terminal 4. A "terminal" or "node" may refer to a point of connection in the monolithically-integrated circuit 1 to allow the flow of current and/or to apply a voltage, such as the first and/or the second reference voltage discussed below. In Fig. 1, the first terminal 3 and the second terminal 4 are displayed as signal lines and any point of the respective signal lines may serve as the respective first terminal 3 and second terminal 4, e.g., a point of the signal line which is at a border of the monolithically-integrated circuit (e.g., at or close to an edge).

The first terminal 3 is configured to receive a first reference voltage signal for an ON-state of the RF switch 2. Thus, the first terminal 3 may serve as an input terminal for the first reference voltage. The first reference voltage (also referred to as "ON-state voltage") may indicate a mode in which the RF switch 2 is operational or conducting (i.e., in an ON mode). The presence of the first reference voltage may thus put (drive) the RF switch 2 into the ON-state.

The second terminal 4 is configured to receive a second reference voltage signal for an OFF-state of the RF switch 2. Thus, the second terminal 4 may serve as an input terminal for the second reference voltage. The second reference voltage (also referred to as "OFF-state voltage") may indicate a mode in which the RF switch 2 is non-operational or non-conducting (i.e., in an OFF mode). The presence of the second reference voltage may thus drive the RF switch 2 in absence of the first reference voltage. In some examples, the second reference voltage is applied continuously and may thus serve as a baseline voltage. In other examples, the second reference voltage is only applied when the first reference voltage is not applied. It should be noted that the second reference voltage may also include zero (Volts).

The monolithically-integrated circuit 1 further includes decoder circuitry 5. The decoder circuitry 5 is configured to decode a control sequence encoded in at least one of the first and the second voltage signals for controlling a switch state of the RF switch.

The decoder circuitry 5 may be provided as a digital decoder. In that case, the control sequence may also be a digital sequence encoded in the first and/or the second voltage signal. In some examples, the decoder may be implemented as a digital counter configured to count the number or arrived pulses and to output a result of the counting, e.g., as a binary number (bit). Each bit may be used to control the respective switch. In some examples, the decoder may be further configured to store the received control sequence in a shift register and to decode the stored combination, e.g., using a Boolean function implemented with logic gates. In some examples, the decoder may be monolithically integrated on an RF switch IC (integrated circuit) and may be implemented using technologies such as CMOS logic, CML (current-mode logic), SCL (source-coupled logic), or the like. On the other hand, if the decoder circuitry is implemented as an analog decoder, the control sequence may be an analog sequence encoded in the first and/or second voltage signal. In an analog decoder, applied voltage levels may be discriminated to extract information from the control sequence.

The control sequence may be provided based on a modulation of the respective reference voltage (or both). For example, an amplitude (or a voltage level) may be changed in a fashion to represent a specific pattern which, when the decoder circuitry receives this pattern, indicates a switch state of the RF switch 2. For example, the RF switch 2 may provide a plurality of switch states which can all be represented as a corresponding number of patterns encoded in the control sequence. Hence, each pattern of the control sequence may indicate a particular switch state of the RF switch 2. In some examples, the control sequence may encode the switch state based on a phase-modulation of any of the first and the second reference voltages. In some examples, pulse modulation may be applied for encoding the control sequence. In some examples, combinations of at least two of the above-mentioned techniques for encoding the control sequence may be applied.

In some examples, only the first reference voltage encodes the control sequence, and in other examples, only the second reference voltage encodes the control sequence. On the other hand, in some examples, both the first and the second reference voltage encode the control sequence. In such examples, for example, differential encoding/decoding may be applied, in which a difference between the first and the second reference voltages indicates the control sequence.

In the present example of Fig. 1, the decoder circuitry 5 only receives the first reference voltage as it is connected with the first terminal 3, but not with the second terminal 4. However, as indicated above, in some examples, the decoder circuitry 5 is connected with both terminals for receiving the first and the second reference voltage or only with the second terminal 4 for only receiving the second reference voltage.

There may be various ways how the decoder circuitry 5 decodes the control sequence and the present disclosure is not limited to a particular way. For example, the decoder circuitry 5 may store or have access to a table in which the respective control sequence is associated with a respective switch state. In some examples, the decoder may be based on a logic configured to assign a predetermined control sequence with a predetermined switch state.

The monolithically-integrated circuit 1 further includes level-shifter circuitry 6. The level shifter circuitry receives both the first and the second reference voltages and thus, is connected with the first terminal 3 and the second terminal 4. Moreover, the level shifter circuitry 6 includes an input that is connected with an output of the decoder circuitry 5. Thereby, the level shifter circuitry 6 is configured to receive a signal from the decoder circuitry 5 indicating the switch state of the RF switch 2.

The level shifter circuitry 6 is configured to adjust, based on the control sequence, the switch state of the RF switch by selectively level-shifting a voltage level of one of the first and the second reference voltage signals and supplying it (i.e., the level-shifted first reference voltage signal or the level-shifted second reference voltage signal) to the RF switch 2. Level-shifting may refer to a process of transforming a voltage signal (such as the first and/or the second reference voltage signal) from one (logic) level to another. In the present disclosure, the level-shifting is carried out for signaling the switch state to the RF switch 2 based on the encoded control sequence. In other words, the level-shifting is done in accordance with the signal received from the decoder circuitry 5.

The switch state may include the ON-state and the OFF-state. Also, different ON-states may be envisaged according to the present disclosure. For example, the switch state refers to a configuration or condition of the RF switch 2 that determines how an input signal is routed through the RF switch 2 and how an output signal may be generated by the RF switch 2. In other words, based on the switch state, one or multiple signal paths may be established in the RF switch 2.

In some examples, the decoder circuitry is further configured to detect a signal edge in at least one of the first reference voltage signal and the second reference voltage signal. The signal edge indicates a beginning of the control sequence. In such examples, the level-shifter circuitry 6 is configured to adjust the switch state of the RF switch 2 based on the control sequence after a predetermined time has elapsed since the signal edge was detected.

Such an example is described in the following under reference of Fig. 2, which depicts a timing diagram 10 for controlling a switch state of the RF switch 2. In a first row of the timing diagram 10, a supply and control voltage 11 is depicted as the first reference voltage signal. It should be noted that in the present example of Fig. 2, (only) the first reference voltage includes the signal edges, but the present disclosure is not limited in that regard. The timing diagram 10 further depicts, in a second row, a mode 12 of the RF switch 2, and in a third row, the switch state 13. The levels of the respective signals (11, 12, and 13) are only for illustrational purposes and should not be construed as binding and they do not represent concrete number or level. For example, the mode 12 or the switch state 13 may only symbolically be depicted in different levels since these states may be logically distinct from each other, but not be represented as different voltages or powers, or the like.

The mode 12 includes, in this example, an RF operation mode 14 (i.e., an ON-mode in an ON-state controlled by the presence of the supply and control voltage 11) and a programming mode 15, but it should be noted that the present disclosure is not limited in that regard since other modes may be present, as well. Moreover, two switch states 13 are depicted, but there may be a plurality of switch states, such as three, four, five, ten, twenty, hundreds, or the like. In general terms, the programming mode 15 may refer to a state in which the monolithically integrated circuit 1 receives and decodes the control sequence. The programming mode may last until the RF switch 2 has received a bias voltage or until a trigger signal is received.

As indicated in Fig. 2, the RF switch 2 is in switch state 1 in the beginning of the timing diagram 10 and the supply and control voltage 11 has a constant voltage level. Then, the supply and control voltage 11 has a first falling edge 16 which triggers the programming mode 15. In this example, the programming mode has a fixed delay 17 which is always of the same duration, and which may be realized by an integrated delay element. During the programming mode 15, a control sequence 18 is decoded by the decoder circuitry 5 and transmitted to the level-shifter circuitry 6 for controlling the switch state 13. The decoder circuitry 5 may, for example, use a predefined algorithm or a lookup table to decode the control sequence. For example, the decoder circuitry 5 may count the pulses and assign the counted number of pulses to a switch state, without limiting the present disclosure in that regard.

As can be taken from the timing diagram 10, at an end of the programming mode 15, switch state 1 arrives at a logic low and switch state 2 arrives at a logic high, i.e., it is switched from state 1 to state 2. After the programming mode 15, the RF operation mode 14 starts again, this time in state 2. The control sequence 18, in this example, is three falling edges which are respectively followed by a rising edge (or in other words: two pulses), such that the supply and control voltage 11 arrives back at the even voltage level of the beginning of the timing diagram 10. However, the present disclosure is not limited to any specific control sequence of pattern. For example, also a step-wise falling or rising of the supply and control voltage 11 may indicate a particular switch state 13.

On the other hand, in some examples, the decoder circuitry 5 may be configured to detect a first signal edge in at least one of the first reference voltage signal and the second reference voltage signal. In such examples, the first signal edge may indicate a beginning of the control sequence. The decoder circuitry 5 may be further configured to detect a second signal edge in at least one of the first reference voltage signal and the second reference voltage signal. The second signal edge follows the first signal edge in time. Furthermore, the first signal edge is a transition from a first signal level to a second signal level and the second signal edge is a transition from the first signal level to a third signal level different from the second signal level. In such examples, the level-shifter circuitry 6 may be further configured to adjust the switch sate of the RF switch 2 upon detection of the second signal edge.

Such examples may realize a variable delay (in contrast to the example of Fig. 2) since the second signal edge may indicate and end of the control sequence or the programming mode.

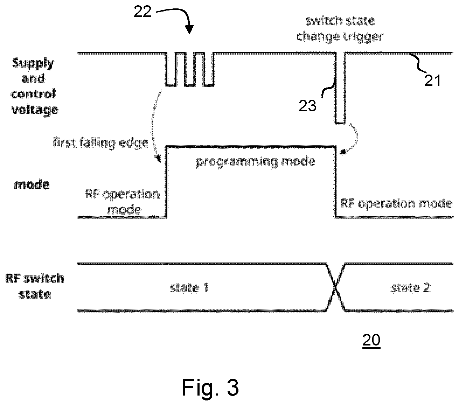

Such an example is discussed in the following under reference of Fig. 3, which depicts a timing diagram 20, which is similar to the timing diagram 10 of Fig. 2, such that a repetitive description of elements already present in Fig. 2 is omitted. However, in contrast the timing diagram 10 of Fig. 2, the timing diagram 20 of Fig. 3 depicts a different supply and control voltage 21 (as the first reference voltage). The supply and control voltage 21 includes a control sequence 22 and a switch state change trigger 23. The control sequence 22 of the supply and control voltage 21 (first reference voltage) includes a first signal edge that is a transition from a first signal level to a second signal level to initiate the programming mode. The supply and control voltage 22 further includes a second signal edge 23 ("switch state change trigger") that is a transition from the first signal level to a third signal level. The third signal level may be different from the second signal level, such that a beginning of the programming mode (initiated by the first signal edge) and the control sequence may be discriminated from an end of the programming mode (initiated by the second signal edge 23). In other words, the programming mode may be initiated by a first falling edge and ended by a second falling edge, wherein the first falling edge may have a different amplitude (or magnitude) level than the second falling edge.

However, the present disclosure is not limited in that regard. Additionally or alternatively, a pulse width may be modulated to initiate and end the programming mode.

Hence, in contrast to the example of Fig. 2, the programming mode is kept on as long as the switch state change trigger 23 is not detected. Thereby, the programming mode can be as short as the control sequence 22 or even be prolonged, if the control sequence 22 becomes longer. In order to indicate the end of the programming mode, the switch state change trigger 23 has a different voltage level (difference) than the control sequence 22, i.e., transitions to a third signal level instead of to the second signal level as the control sequence 22 does.

However, there may be various other ways for indicating the end of the control sequence. For example, a duration of the switch state change trigger 23 may have a predetermined length for indicating the end of the programming mode.

In the example of Fig. 3, the level-shifter circuitry 6 is configured to adjust the switch state of the RF switch upon detection of the second signal edge (switch state change trigger) 23. The level-shifter circuitry 6 may receive a corresponding signal for adjusting the switch state by the decoder circuitry 5, when the decoder circuitry 5 has detected the second signal edge 23.

It should be noted that Figs. 2 and 3 are described such that the supply and control voltage 11 or 21 use amplitude modulation (or voltage level modulation), but as indicated above, the present disclosure is not limited in that regard.

In some examples, the monolithically-integrated circuit further includes a switch and a capacitance coupled between the first terminal and the level-shifter circuitry. In such examples, the switch is configured to open a conductive path between the first terminal and each of the capacitance and the level shifter circuitry while the control sequence is received. Furthermore, the capacitance is configured to provide a supply voltage for the level shifter circuitry when the switch opens the conductive path.

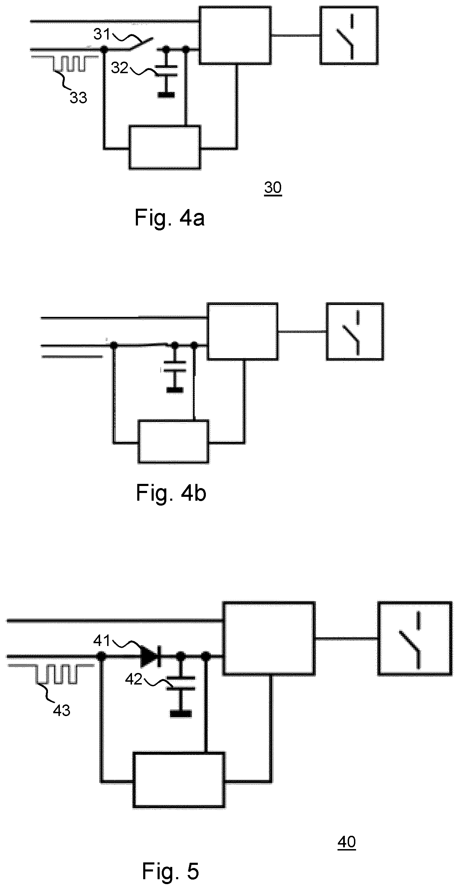

Such an example is discussed in the following under reference of Fig. 4. Figs. 4a and 4b depict a monolithically-integrated circuit 30 according to the present disclosure, which is similar to the monolithically-integrated circuit 1 (repetitive description of elements already present in Fig. 1 is omitted), but further includes a switch 31 (also referred to as hold switch or SW_{hold}) and a capacitance 32 (also referred to as hold capacitance or C_{hold}) coupled between the first terminal and the level-shifter circuitry. The capacitance 32 is coupled to ground, without limiting the present disclosure in that regard. If the switch 31 is in an open state, the capacitance 32 (being connected to the level-shifter circuitry) supplies the level-shifter circuitry with a supply voltage to maintain its functionality.

As depicted in Fig. 4a, when a control sequence 33 is received (e.g., in the programming mode as discussed under reference of Figs. 2 and 3), the switch 31 opens the conductive path, such that the control sequence 33 is transmitted (only) to the decoder circuitry which then signals the level-shifter circuitry the switch state.

On the other hand, when no control sequence is received, as depicted in Fig. 4b, the switch 31 is in a closed state and established a conductive path to the level-shifter circuitry.

In some examples, the monolithically-integrated circuit includes a non-linear element and a capacitance coupled between the first terminal and the level-shifter circuitry. The non-linear element is configured to break a conductive path between the first terminal and each of the capacitance and the level shifter circuitry when the first reference voltage signal exhibits a first voltage level while receiving the control sequence. The capacitance is configured to sustain a supply voltage for the level shifter circuitry when the non-linear element breaks the conductive path.

A non-linear element may refer to an element whose output voltage (or current) does not change proportionally to its input voltage (or current). The non-linear element may include at least one of a diode, a transistor, and the like. The non-linear element may establish a conductive path when the first reference voltage reaches a predetermined voltage level. For example, in case of a diode, the first reference voltage signal may need to be higher than the breakdown voltage of the diode during the ON-state. On the other hand, for receiving the control sequence (e.g., in the programming mode), the first reference voltage signal may lie below the breakdown voltage of the diode, such that the control sequence is (only) transmitted to the decoder circuitry. The capacitance may be dimensioned to sustain a supply voltage for the level-shifter circuitry when the non-linear element breaks the conductive path.

Such an example is discussed in the following under reference of Fig. 5 which depicts a monolithically-integrated circuit 40 that includes a diode 41 (also referred to as charge diode or D_{charge}) and a capacitance 42 (also referred to as hold capacitance or C_{hold}). Fig. 5 shows the case that a control sequence is input. The signal level or voltage level of the control sequence lies below the breakdown voltage of the diode 41. Hence, the diode 41 breaks the conductive path between the first terminal and the level-shifter circuitry. A supply voltage for the level-shifter circuitry is thus provided/sustained by the capacitance 42 as long as the control sequence 43 is received or as long as the programming mode is kept on.

In some examples, the level shifter circuitry 6 is further configured to adjust the switch state of the RF switch 2, if it is determined that the control sequence includes an identifier of the monolithically-integrated circuit.

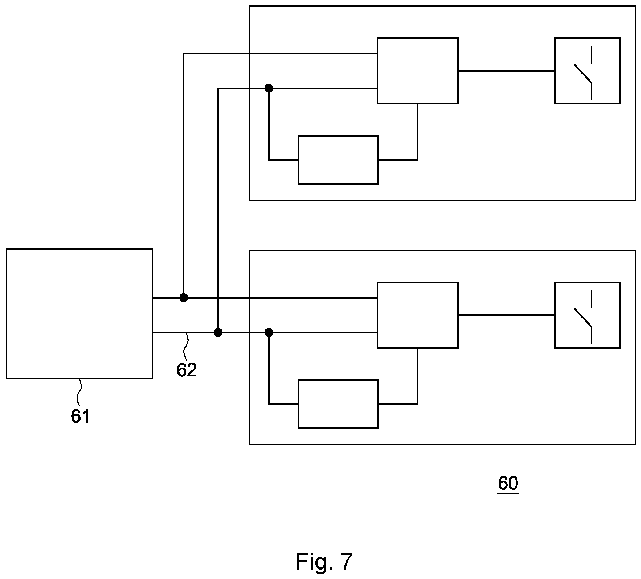

For example, a system (such as the system discussed in the following under reference with Fig. 7) may include a plurality (e.g., at least two) of RF switches and thus, a plurality (e.g., at least two) of monolithically-integrated circuits (in some instances, one monolithically-integrated circuit includes more than one RF switch). If each monolithically-integrated circuit is provided with a (the) same first reference voltage signal, the identifier of the apparatus included in the control sequence indicates which of the plurality of RF switches is supposed to change the switch state. Also, multiple identifiers may be included in the control sequence identifying respective monolithically-integrated circuits.

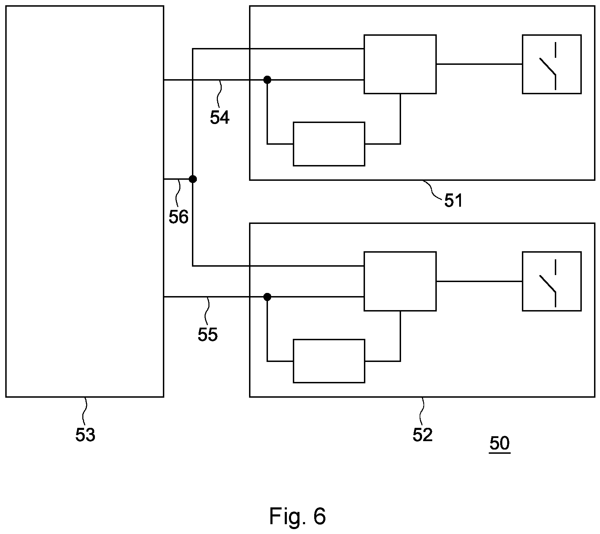

**Fig. 6** depicts a system 50 including a plurality of monolithically-integrated circuits according to the present disclosure. Fig. 6 only depicts two monolithically-integrated circuits 51 and 52, but the present disclosure is not limited to any number of monolithically-integrated circuits included in a system. The circuitry in each of the monolithically-integrated circuits 51 and 52 corresponds to the circuitry discussed above under reference of Fig. 1, such that a repetitive description thereof is omitted.

The system 50 further includes power management circuitry 53 configured to supply separate first reference voltage signals for each of the plurality of monolithically-integrated circuits. To do so, the power management circuitry 53 includes a plurality of output terminals 54 and 55 (depicted as dedicated signal lines) provided for the monolithically-integrated circuits 51 and 52, respectively. Hence, in this example, each of the plurality of monolithically-integrated circuits is provided with a separate first reference voltage signal. Accordingly, the example of Fig. 6 depicts the case that the control sequence does not include an identifier to assign a control sequence to a respective monolithically integrated circuit (in contrast to the example of Fig. 7 as discussed below).

In other words, in some examples, the power management circuitry 53 is configured to supply a separate first reference voltage signal to each of the plurality of monolithically-integrated circuits. The power management circuitry may be based on an application specific integrated circuit (ASIC), a field programmable gate array (FPGA), a power management integrated circuit (PMIC), or the like. The power management circuitry may optionally be coupled to, e.g., read only memory (ROM) for storing software, random access memory (RAM) and/or non-volatile memory.

As indicated above, in some examples the power management circuitry 53 includes a plurality of output terminals 54 and 55, each output terminal 54 and 55 being connected to a respective first terminal of the plurality of monolithically-integrated circuits 51 and 52. Thereby, the power management circuitry 53 is configured to output a respective one of the separate first reference voltage signals to a respective monolithically-integrated circuit 51 and 52.

In this example, the power management circuitry 53 supplies a (the) same second reference voltage signal to the plurality of monolithically-integrated circuits as indicated by second reference voltage signal line 56 being connected to the respective second terminals of the plurality of monolithically-integrated circuits 51 and 52. However, the present disclosure is not limited in that regard as the second reference voltage signal may be supplied from a different source or from many voltage sources.

As indicated above, in some examples, each monolithically-integrated circuit may be provided with a (the) same first reference voltage signal and an identifier may be included which indicates which of the plurality of monolithically-integrated circuit is to adjust the switch state.

Such an example is discussed in the following under reference of Fig. 7 which depicts a system 60 according to the present disclosure. The system 60 includes a power management circuitry 61 which is configured to supply a same first reference voltage signal to all of the plurality of monolithically-integrated circuits, as discussed above.

The power management circuitry 61 is further configured to generate the control sequence in the first reference voltage signal to include a respective identifier indicating which of the plurality of monolithically-integrated circuits is to adjust the switch state of its corresponding RF switch based on the control sequence, as discussed above.

In some examples, the power management circuitry 61 includes an output terminal 62 configured to output the first reference voltage signal. The first terminals of the plurality of monolithically-integrated circuits are (all or a subset) coupled to the same output terminal (e.g., the output terminal 62 depicted as a first reference voltage signal line).

In some examples, the power management circuitry is configured to supply a (the) same second reference voltage signal to the plurality of monolithically-integrated circuits, as discussed above.

In some examples, the power management circuitry 53 or 61 is monolithically-integrated.

While in Fig. 6 each monolithically-integrated circuit (also referred to as "slave device") may require an individual reference signal and control line, in the example of Fig. 7 the first reference voltage signal lines are shared between the slave devices. The switch control may be performed by modulating one of the reference voltages, for which the decoder circuitry is configured to extract the unique slave ID and switches only the addressed devices. This example may require more complex digital decoder as in the embodiment in Fig. 6, thus on one hand reducing an area saving benefit offered by the example of Fig. 6, but on the other hand, reducing the complexity of routing (and the number of output terminals) on an application level.

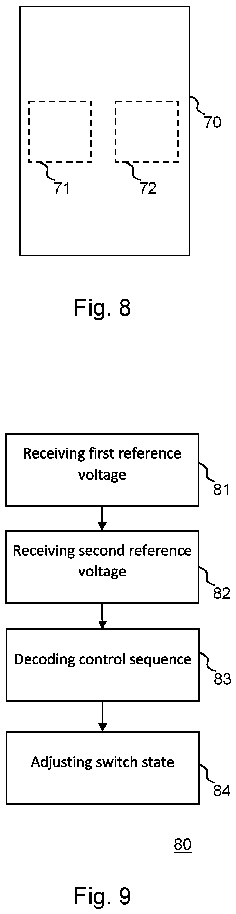

**Fig. 8** depicts a wireless communication device 70. As indicated with dashed lines, the wireless communication device optionally includes (one of) a monolithically-integrated circuit 71 according to the present disclosure or a system 72 according to the present disclosure.

The wireless communication device 70 may be any of a mobile phone, a feature phone, a smartphone, a phablet (hybrid device between a tablet and a smartphone), a wearable mobile device (e.g., smartwatch, smart glasses, smart earbuds/headphones, smart lenses, etc.), a tablet with cellular connectivity, a satellite phone, a mobile hotspot, a repeater, a router, an electronic reader, a connected vehicle (with integrated mobile communication capabilities), an loT (internet of things) device with mobile connectivity (e.g., smart home devices, sensors, or the like), or the like.

In some examples, the monolithically-integrated circuit 71 or the system 72 is configured to selectively couple an antenna of the wireless communication device 70 with tuning circuitry for adjusting one or more electrical properties of the antenna based on a switch control signal.

For example, the wireless communication device 70 may include one or more antennas which may be controlled based on the switch control signal generated by the tuning circuitry. In other words, the tuning circuitry may be configured to tune the one or more antennas with the switch control signal. The monolithically-integrated circuit 71 or the system 72 may establish a conductive path between the tuning circuitry and the respective antenna based on a switch state of a respective RF switch. Accordingly, the wireless communication device 70 may be configured to receive and transmit different wireless signals in accordance with the respective switch state of a respective RF switch.

**Fig. 9** depicts a method 80 for operating an RF switch of a monolithically-integrated circuit. The method may be carried out with any of the monolithically-integrated circuits, systems, or the device discussed herein.

The method includes receiving, 81, at a first terminal of the monolithically-integrated circuit, a first reference voltage signal for an ON-state of the RF switch. The method further includes receiving, 82, at a second terminal of the monolithically-integrated circuit, a second reference voltage signal for an OFF-state of the RF switch. The method further includes decoding, 83, a control sequence encoded in at least one of the first and the second voltage signals for controlling a switch state of the RF switch. The method further includes adjusting, 84, based on the control sequence, the switch state of the RF switch by selectively level-shifting a voltage level of one of the first and the second reference voltage signals and supplying the level-shifted first reference voltage signal or the level-shifted second reference voltage signal to the RF switch, as discussed herein.

As mentioned in the outset, in conventional implementations, a PMU&Control unit may occupy a lot of space of an IC die. Moreover, when sharing the supply/control interface, the tuner ICs may need to cope with digital traffic on the bus (e.g., MIPI bus) while operating in a sensitive RF environment, meaning that glitches and spurs from the digital bus must not couple into the RF signal path of the switch. This requirement may create a need for special design measures to prevent digital spikes propagation from the control to the signal portion on chip, which is provided according to the present disclosure. Also, the present disclosure may provide for smaller implementation dimensions and less components (or circuitry) may need to be integrated (e.g., a reference voltage generator, a charge pump, or the like).

The embodiments and examples of the present disclosure, however, may eliminate the need for an integrated reference voltage generator and a charge pump, thereby reducing the amount of PMU&Control circuitry monolithically-integrated on chip - and also reducing the amount of silicon area needed.

The power management circuitry of the present disclosure may be implemented in a separate IC configured to supply and individually control the respective RF switch ICs by means of a shared or partly shared interface.

Moreover, according to the present disclosure, a separate control of tuners (or RF switches) may be achieved (instead of a shared bus), thereby eliminating the need for digital signal suppression and coupling prevention, since the respective monolithically-integrated circuit may be addressed only if a change of the switch state is required. This may further reduce complexity of the power management circuitry and may further reduce die area required for its implementation.

The aspects and features described in relation to a particular one of the previous examples may also be combined with one or more of the further examples to replace an identical or similar feature of that further example or to additionally introduce the features into the further example.

More details and aspects of the methods discussed herein are explained in connection with the proposed technique or in one or more examples described above (e.g., Figs. 1 to 8). The methods may include one or more additional optional features corresponding to one or more aspects of the proposed technique or one or more examples described above.

The examples and embodiments described herein may be summarized as follows:
An example (e.g., example 1) relates to a monolithically-integrated circuit. The monolithically-integrated circuit includes an RF switch. The monolithically-integrated circuit further includes a first terminal configured to receive a first reference voltage signal for an ON-state of the RF switch. The monolithically-integrated circuit further includes a second terminal configured to receive a second reference voltage signal for an OFF-state of the RF switch. The monolithically-integrated circuit further includes decoder circuitry configured to decode a control sequence encoded in at least one of the first and the second voltage signals for controlling a switch state of the RF switch. The monolithically-integrated circuit further includes level-shifter circuitry configured to adjust, based on the control sequence, the switch state of the RF switch by selectively level-shifting a voltage level of one of the first and the second reference voltage signals and supplying the level-shifted first reference voltage signal or the level-shifted second reference voltage signal to the RF switch.

Another example (e.g., example 2) relates to a previous example (e.g., example 1). In this example, the decoder circuitry is further configured to detect a signal edge in at least one of the first reference voltage signal and the second reference voltage signal. The signal edge indicates a beginning of the control sequence. The level-shifter circuitry is configured to adjust the switch state of the RF switch based on the control sequence after a predetermined time has elapsed since the signal edge was detected.

Another example (e.g., example 3) relates to a previous example (e.g., example 1). In this example, the decoder circuitry is further configured to detect a first signal edge in at least one of the first reference voltage signal and the second reference voltage signal. The first signal edge indicates a beginning of the control sequence. The decoder circuitry is further configured to detect a second signal edge in at least one of the first reference voltage signal and the second reference voltage signal. The second signal edge follows the first signal edge in time. The first signal edge is a transition from a first signal level to a second signal level and the second signal edge is a transition from the first signal level to a third signal level different from the second signal level. The level-shifter circuitry is configured to adjust the switch state of the RF switch upon detection of the second signal edge.

Another example (e.g., example 4) relates to a previous example (e.g., any one of examples 1 to 3). In this example the monolithically-integrated circuit further includes a switch and a capacitance coupled between the first terminal and the level-shifter circuitry. The switch is configured to open a conductive path between the first terminal and each of the capacitance and the level shifter circuitry while the control sequence is received. The capacitance is configured to provide a supply voltage for the level shifter circuitry when the switch opens the conductive path.

Another example (e.g., example 5) relates to a previous example (e.g., any one of examples 1 to 3). In this example, the monolithically-integrated circuit further includes a non-linear element and a capacitance coupled between the first terminal and the level-shifter circuitry. The non-linear element is configured to break a conductive path between the first terminal and each of the capacitance and the level shifter circuitry when the first reference voltage signal exhibits a first voltage level while receiving the control sequence. The capacitance is configured to sustain a supply voltage for the level shifter circuitry when the non-linear element breaks the conductive path.

Another example (e.g., example 6) relates to a previous example (e.g., any one of examples 1 to 5). In this example, the level shifter circuitry is further configured to adjust the switch state of the RF switch, if it is determined that the control sequence includes an identifier of the monolithically-integrated circuit.

An example (e.g., example 7) relates to a system including a plurality of monolithically-integrated circuits (e.g., according to any one of examples 1 to 6). The system further includes power management circuitry configured to supply the first reference voltage signal for the plurality of monolithically-integrated circuits.

Another example (e.g., example 8) relates to a previous example (e.g., example 7). In this example, the power management circuitry is further configured to supply a separate first reference voltage signal to each of the plurality of monolithically-integrated circuits.

Another example (e.g., example 9) relates to a previous example (e.g., example 8). In this example, the power management circuitry includes a plurality of output terminals. Each output terminal is connected to a respective first terminal of the plurality of monolithically-integrated circuits, such that the power management circuitry is configured to output a respective one of the separate first reference voltage signals to a respective monolithically-integrated circuit.

Another example (e.g., example 10) relates to a previous example (e.g., example 7). In this example, the power management circuitry is configured to supply a same first reference voltage signal to all of the plurality of monolithically-integrated circuits. The power management circuitry is further configured to generate the control sequence in the first reference voltage signal to include a respective identifier. The respective identifier indicates which of the plurality of monolithically-integrated circuits is to adjust the switch state of its corresponding RF switch based on the control sequence.

Another example (e.g., example 11) relates to a previous example (e.g., example 10). In this example, the power management circuitry includes an output terminal configured to output the first reference voltage signal. The first terminals of the plurality of monolithically-integrated circuits are coupled to the same output terminal.

Another example (e.g., example 12) relates to a previous example (e.g., any one of example 7 to 11). In this example, the power management circuitry is configured to supply a same second reference voltage signal to the plurality of monolithically-integrated circuits.

Another example (e.g., example 13) relates to a previous example (e.g., any one of examples 7 to 12). In this example, the power management circuitry is monolithically-integrated.

An example (e.g., example 14) relates to a wireless communication device including a monolithically-integrated circuit (e.g., according to any one of examples 1 to 6) or a system (e.g., according to any one of examples 7 to 13).

Another example (e.g., example 15) relates to a previous example (e.g., example 14). In this example, the monolithically-integrated circuit or the system is configured to selectively couple an antenna of the wireless communication device with tuning circuitry for adjusting one or more electrical properties of the antenna based on a switch control signal.

An example (e.g., example 16) relates to a method for operating an RF switch of a monolithically-integrated circuit. The method includes receiving, at a first terminal of the monolithically-integrated circuit, a first reference voltage signal for an ON-state of the RF switch. The method further includes receiving, at a second terminal of the monolithically-integrated circuit, a second reference voltage signal for an OFF-state of the RF switch. The method further includes decoding a control sequence encoded in at least one of the first and the second voltage signals for controlling a switch state of the RF switch. The method further includes adjusting, based on the control sequence, the switch state of the RF switch by selectively level-shifting a voltage level of one of the first and the second reference voltage signals and supplying the level-shifted first reference voltage signal or the level-shifted second reference voltage signal to the RF switch.

An example (e.g., example 17) relates to a monolithically-integrated RF switch arrangement including an RF switch and two supply and control pins. An OFF-state reference voltage required for RF switch biasing is applied to the first pin and an ON-state reference voltage required for the RF switch biasing is applied to the second pin. Said voltages may be pulse or amplitude modulated for controlling the switch. The RF switch arrangement may further include a digital decoder and a level shifter for receiving the pulse/amplitude modulated voltages at the two supply and control pins and changing the state of the RF switch upon arrival of the control sequence.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A monolithically-integrated circuit (1; 30; 40; 51, 52), comprising:
a radio frequency, RF, switch (2);
a first terminal (3) configured to receive a first reference voltage signal (11; 21) for an ON-state of the RF switch (2);
a second terminal (4) configured to receive a second reference voltage signal (14) for an OFF-state of the RF switch (2);
decoder circuitry (5) configured to decode a control sequence (18; 22; 33; 43) encoded in at least one of the first (11; 21) and the second (14) reference voltage signals for controlling a switch state of the RF switch (2);
level-shifter circuitry (6) configured to adjust, based on the control sequence (18; 22; 33; 43), the switch state of the RF switch (2) by selectively level-shifting a voltage level of one of the first (11; 21) and the second (14) reference voltage signals and supplying the level-shifted first reference voltage signal (11;21) or the level-shifted second reference voltage signal (14) to the RF switch (2).

2. The monolithically-integrated circuit (1; 30; 40; 51, 52) of claim 1, wherein the decoder circuitry (5) is further configured to detect a signal edge (18) in at least one of the first reference voltage signal (11) and the second reference voltage signal (14), the signal edge (18) indicating a beginning of the control sequence (18), and wherein the level-shifter circuitry (6) is configured to adjust the switch state of the RF switch (2) based on the control sequence (18) after a predetermined time has elapsed since the signal edge (16) was detected.

3. The monolithically-integrated circuit (1; 30; 40; 51, 52) of claim 1, wherein the decoder circuitry (5) is further configured to:
detect a first signal edge in at least one of the first reference voltage signal (21) and the second reference voltage signal (14), wherein the first signal edge indicates a beginning of the control sequence (22); and
detect a second signal edge (23) in at least one of the first reference voltage signal (21) and the second reference voltage signal (14), wherein the second signal edge (23) follows the first signal edge in time, wherein the first signal edge is a transition from a first signal level to a second signal level and the second signal edge is a transition from the first signal level to a third signal level different from the second signal level, and
wherein the level-shifter circuitry (6) is configured to adjust the switch state of the RF switch (2) upon detection of the second signal edge.

4. The monolithically-integrated circuit (30) of any one of the previous claims, further comprising a switch (31) and a capacitance (32) coupled between the first terminal (3) and the level-shifter circuitry (6), wherein:
the switch (31) is configured to open a conductive path between the first terminal (3) and each of the capacitance (31) and the level shifter circuitry (6) while the control sequence (33) is received, and
the capacitance (31) is configured to provide a supply voltage for the level shifter circuitry (6) when the switch (31) opens the conductive path.

5. The monolithically-integrated circuit (40) of any one of claims 1 to 3, further comprising a non-linear element (41) and a capacitance (42) coupled between the first terminal (3) and the level-shifter circuitry (6), wherein:
the non-linear element (41) is configured to break a conductive path between the first terminal (3) and each of the capacitance (42) and the level shifter circuitry (6) when the first reference voltage signal (11; 21) exhibits a first voltage level while receiving the control sequence (43), and
the capacitance (42) is configured to sustain a supply voltage for the level shifter circuitry (6) when the non-linear element (41) breaks the conductive path.

6. The monolithically-integrated circuit (1; 30; 40; 51, 52) of any one of the previous claims, wherein the level shifter circuitry (6) is further configured to:
adjust the switch state of the RF switch (2), if it is determined that the control sequence (18; 22; 33; 43) includes an identifier of the monolithically-integrated circuit (1; 30; 40; 51, 52).

7. A system (50; 60) comprising:
a plurality of monolithically-integrated (1; 30; 40; 51, 52) circuits according to any one of claims 1 to 6; and
power management circuitry (53; 61) configured to supply the first reference voltage signal (11; 21) for the plurality of monolithically-integrated circuits (1; 30; 40; 51, 52).

8. The system (50) of claim 7, wherein the power management circuitry (53) is further configured to supply a separate first reference voltage signal to each of the plurality of monolithically-integrated circuits (51, 52).

9. The system (50) of claim 8, wherein the power management circuitry (53) comprises a plurality of output terminals (54, 55), each output terminal (54, 55) being connected to a respective first terminal (3) of the plurality of monolithically-integrated circuits (51, 52), such that the power management circuitry (53) is configured to output a respective one of the separate first reference voltage signals (11; 21) to a respective monolithically-integrated circuit (51, 52).

10. The system (60) of claim 7, wherein the power management circuitry (61) is configured to:
supply a same first reference voltage signal (11; 21) to all of the plurality of monolithically-integrated circuits (51, 52); and
generate the control sequence (18; 22; 33; 43) in the first reference voltage signal (11; 21) to include a respective identifier, wherein the respective identifier indicates which of the plurality of monolithically-integrated circuits (51, 52) is to adjust the switch state of its corresponding RF switch (2) based on the control sequence (18; 22; 33; 43).

11. The system of claim 10, wherein the power management circuitry (61) comprises an output terminal (62) configured to output the first reference voltage signal, and wherein the first terminals of the plurality of monolithically-integrated circuits are coupled to the same output terminal.

12. The system of any one of claims 7 to 11, wherein the power management circuitry is configured to supply a same second reference voltage signal to the plurality of monolithically-integrated circuits.

13. A wireless communication device comprising a monolithically-integrated circuit according to any one of claims 1 to 6 or a system according to any one of claims 7 to 12.

14. The wireless communication device of claim 13, wherein the monolithically-integrated circuit or the system is configured to selectively couple an antenna of the wireless communication device with tuning circuitry for adjusting one or more electrical properties of the antenna based on a switch control signal.

15. A method for operating a radio frequency, RF, switch of a monolithically-integrated circuit, the method comprising:
receiving, at a first terminal of the monolithically-integrated circuit, a first reference voltage signal for an ON-state of the RF switch;
receiving, at a second terminal of the monolithically-integrated circuit, a second reference voltage signal for an OFF-state of the RF switch;
decoding a control sequence encoded in at least one of the first and the second voltage signals for controlling a switch state of the RF switch; and
adjusting, based on the control sequence, the switch state of the RF switch by selectively level-shifting a voltage level of one of the first and the second reference voltage signals and supplying the level-shifted first reference voltage signal or the level-shifted second reference voltage signal to the RF switch.
